(19) Europäisches Patentamt
European Patent Office
Office européen des brevets

(11) **EP 2 573 794 B1**

(12) **EUROPEAN PATENT SPECIFICATION**

(45) Date of publication and mention of the grant of the patent:
**23.03.2022 Bulletin 2022/12**

(21) Application number: **11783229.5**

(22) Date of filing: **11.05.2011**

(51) International Patent Classification (IPC):
***H01J 37/20*** *(2006.01)*      ***H01J 37/28*** *(2006.01)*

(52) Cooperative Patent Classification (CPC):
**H01J 37/28; H01J 37/20; H02P 29/60;**
H01J 2237/2001; H01J 2237/20221;
H01J 2237/20278

(86) International application number:
**PCT/JP2011/002605**

(87) International publication number:
**WO 2011/145290 (24.11.2011 Gazette 2011/47)**

(54) **SCANNING ELECTRON MICROSCOPE**

RASTERELEKTRONENMIKROSKOP

MICROSCOPE ÉLECTRONIQUE À BALAYAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.05.2010  JP 2010115887**

(43) Date of publication of application:
**27.03.2013  Bulletin 2013/13**

(73) Proprietor: **Hitachi High-Tech Corporation
Minato-ku
Tokyo 105-6409 (JP)**

(72) Inventors:
• **HANEDA, Shigeru
Tokyo 105-6409 (JP)**
• **TAKAHASHI, Kaname
Tokyo 105-6409 (JP)**
• **SAKAMOTO, Naoki
Tokyo 105-6409 (JP)**
• **KAWANISHI, Shinsuke
Tokyo 105-6409 (JP)**

(74) Representative: **Strehl Schübel-Hopf & Partner
Maximilianstrasse 54
80538 München (DE)**

(56) References cited:
JP-A- 9 223 477      JP-A- 11 235 082
JP-A- H11 235 082    JP-A- 2001 173 654
JP-A- 2004 357 426   JP-A- 2005 123 129
JP-A- 2005 333 114   JP-A- 2006 238 638
JP-A- 2006 238 638   US-A1- 2005 230 637

EP 2 573 794 B1

## Description

## Technical Field

The present invention relates to a sample-moving stage of a scanning electron microscope.

## Background Art

In a scanning electron microscope, an object to be observed is usually rested on a sample mount. Then, the sample mount is moved by a sample stage driven by a stepping motor, a piezoelectric element, or the like. Patent Document 1, for example, discloses an invention made for accurately moving a visual field even when a stage has a backlash or a feed screw has a pitch error.

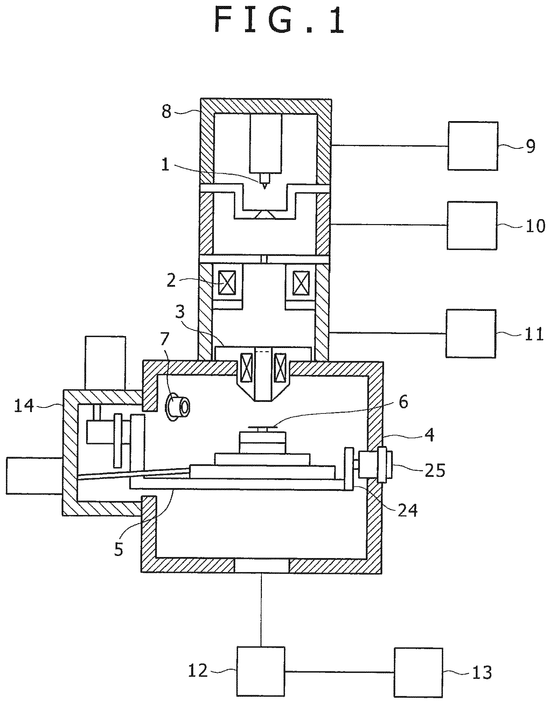

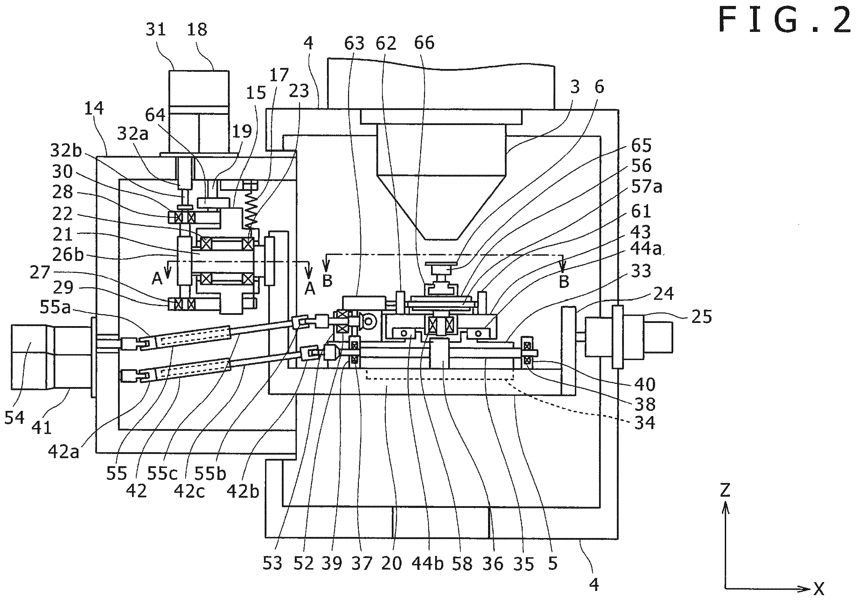

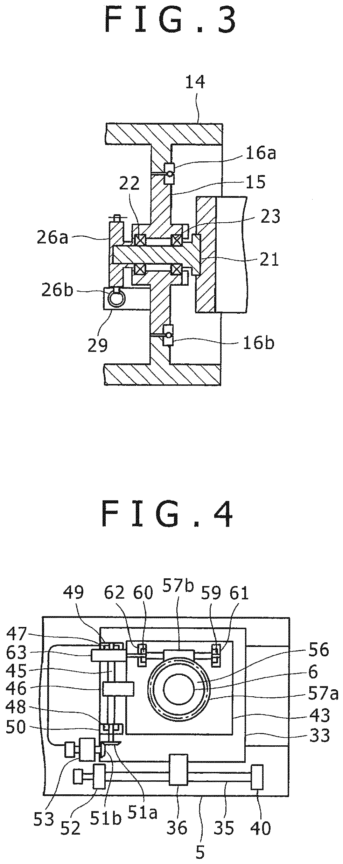

A prior-art scanning electron microscope (SEM) is shown in Fig. 1 , details of a sample-moving stage thereof in Fig. 1 are shown in Fig. 2 , a cross-sectional view taken along line A-A in Fig. 2 is shown in Fig. 3 , and an external view from a direction of arrows, taken along line B-B in Fig. 2 , is shown in Fig. 4 . The scanning electron microscope, used to observe a shape of a sample surface, irradiates, through condenser lenses 2 and an objective lens 3, the surface of the sample 6 mounted on the sample-moving stage 5 inside a sample chamber 4, while scanning this sample surface with an electron beam generated by an electron gun 1, and then uses a secondary-electron detector 7 to capture a secondary electron originating from the sample.

Reference numbers 9 to 13 in Fig. 1 denote vacuum pumps that create a vacuum in the sample chamber 4, an electron gun chamber 8, and the like. A stage casing 14 is installed on a side of the sample chamber 4, and a z-table 15 is coupled to the stage casing 14 via cross roller bearings 16a and 16b. The z-table 15 is pulled upward by a spring 17, then guided along cross roller guides 16a and 16b, and driven by rotation of a z-stepping motor 18. This makes a male screw of a z-moving shaft 19 and a female screw 64 mounted on the z-table 15, properly act to move the z-table 15 and thus to move the sample 6 in a z-direction.

A tilting shaft 21 is mounted at one end of a tilting table 20, and the tilting shaft 21 is pivotally coupled to the z-table 15 via roller bearings 22 and 23. A locking plate 24 is mounted at the other end of the tilting table 20 and pushed by a stage-locking mechanism 25 mounted in the sample chamber 4. A worm wheel 26a is fitted at an end of the tilting shaft 21, and a worm gear 26b formed to be combined with the worm wheel 26a is supported by ball bearings 27 and 28 and connected to the z-table 15 via bearing housings 29 and 30. The worm wheel 26a and a T-stepping motor 31 that rotates the worm gear 26b are coupled to each other by spline shafts 32a and 32b so as to be able to follow a movement of the z-moving member 15 in the z-direction. Rotation of the T-stepping motor 31 rotates the tilting shaft 21, thus tilts the sample 6, and retains the sample 6 at a fixed tilt angle.

An x-table 33 that moves the sample 6 in an x-direction is mounted on the tilting table 20 via a cross roller guide 34. The x-table 33 is driven by a feed action of an x-ball screw 35 and an x-ball screw nut 36. The x-ball screw nut 36 is fixed to the x-table 33. The x-ball screw 35 is supported at both ends thereof by ball bearings 37 and 38, and is connected to the tilting table 20 at bearing housings 39 and 40. The x-ball screw 35 and an x-stepping motor 41 that rotates the x-ball screw 35 are coupled to each other by an x-stage joint 42. The x-stage joint 42 includes one pair of joint portions, 42a and 42b, for angle follow-up, and a telescopic portion 42c for length control with a ball spline. The x-table 33 drives the x-stepping motor 41 to rotate the x-ball screw 35 via the x-stage joint 42 and feed the x-ball screw nut 36. This feed action moves the x-table 33 in the x-direction, hence moving the sample in the x-direction.

A y-table 43 is mounted on the x-table 33 via cross roller guides 44a and 44b. The y-table 43 is driven by a feed action of a y-ball female screw 45 and a y-ball screw nut 46. The y-ball screw nut 46 is fixed to the y-table 43. The y-ball screw 45 is supported at both ends thereof by ball bearings 47 and 48, and is connected to the x-table 33 at bearing housings 49 and 50. A bevel gear 51a is fitted at one end of the y-ball screw 46, and a bevel gear 51b that meshes with the bevel gear 51a is supported by a ball bearing (not shown) and fixed at a bearing housing 53 to the x-table. The bevel gear 51b is coupled to a y-stepping motor 54 that rotates the y-ball screw 45, by a y-stage joint 55. The y-stage joint 55 includes one pair of joint portions, 55a and 55b, for angle follow-up, and a telescopic portion 55c for length control with a ball spline. The y-table 43 drives the stepping motor 54 to rotate the bevel gears 51a, 51b and the y-ball screw 45 via the y-stage joint 55 and feed the y-ball screw nut 46. This feed action moves the y-table 43 in a y-direction, hence moving the sample in the y-direction.

A rotation table 56 has a worm wheel 57a and is pivotally coupled to the y-table 43 by a ball bearing 58. A worm gear 57b is supported at both ends thereof by ball bearings 59 and 60, and is connected to the y-table 43 at bearing housings 61 and 62. The worm gear 57b is rotated by a DC motor 63. Rotation of the DC motor 63 turns the worm gear 57b and the worm wheel 57a, thus rotating the rotation table 56 and hence the sample.

The sample 6 is mounted in bonded form on a sample holder 65, and the sample holder 65 is inserted in and fixed to a holder stage 66 mounted on the rotation table 56. In this form, the sample is fed in the x-, y-, z-directions, rotated, and tilted.

The document JP 9 22 3477 describes a further scanning electron microscope according to the prior art. The document JP H11 235082 A discloses a wafer stage in a projection apparatus wherein the variations of the power consumption of the armature winding of a linear motor are suppressed.

**Prior Art Literature**

**Patent Documents**

Patent Document 1: JP-1998-129985-A

**Summary of the Invention**

**Problems to be Solved by the Invention**

In the prior art, the stepping motors for driving the x- and y-tables are installed in a stage casing that is placed outside a vacuum region. The x-stage joint and other elements of a motive force transmission system are arranged between an output shaft of the x-stepping motor and the x-ball screw, and this section generates a backlash and torsional deformation. The scanning electron microscope then decreases in response characteristics, particularly during startup or reversing of the x- and y-tables. For example, for operations with a trackball, since it has been necessary to turn the ball before an image starts to move, table driving, that is, moving the image, has decreased in operational convenience. Referring to the y-table, response characteristics of its driving system further including the bevel gears having a backlash decrease even more significantly than those of the x-table driving system, with the result that operational convenience further decreases.

These response characteristics are susceptible to the backlash or torsional deformation due to the presence of the power transmission system between the ball screws and the stepping motors that drive the x- and y-tables. The response characteristics can be improved by arranging the motors in a vacuum region and connecting these motors directly to the ball screws via couplings. Heat associated with motor operation, however, has changed temperature of the sample stage, and during observation through the scanning electron microscope, the temperature change has drifted the sample and affected the observation.

A change in a temperature of the scanning electron microscope due to a change in room temperature, for example, has also caused sample drifting and affected the observation.

Means for Solving the Problems

The above problems can be solved by using a method for operating a electron microscope as defined in claim 1. In the scanning electron microscope of this method, a sample-moving stage for moving a sample includes an x-table for moving the sample in an x-direction right-angled to an electron beam, a y-table for moving the sample in a y-direction right-angled to the x-direction as well as to the electron beam, the y-table being mounted above the x-table, a z-table configured to move in a same z-direction as the direction in which the electron beam travels, a rotation table for rotating the sample inside a plane parallel to an x-y plane, and a tilting table for imparting a tilting action to the sample. In the scanning electron microscope, the x-table is mounted on the tilting base, and the x-table and the y-table are moved respectively by motors disposed in a sample chamber, each of the motors being connected to a ball screw via a coupling. The electron beam is scanned on the sample surface, thereby allowing a detector to detect a signal originating from the sample, and this signal, detected by the detector, is used to display an image of the sample. Changes in the amounts of heat generated by the motor are lessened by, during the movement of the sample and a stop of the sample movement, controlling supply currents to the motors so that the supply currents have the same level or so that a maximum difference in level between the supply currents is 20%. This lessens any changes in the amounts of heat generated by the motors, thereby controls temperature of the sample stage, and reduces sample drift during observation.

The control of the temperature is further improved by lowering the level of the supply current to the motor for the y-table, for reduced changes in the amount of heat.

**Effects of the Invention**

As outlined above, a method that enables easy reduction in sample drift is provided in accordance with the present invention.

**Brief Description of the Drawings**

Fig. 1 is a longitudinal cross-sectional side view showing an example related to the invention of a conventional scanning electron microscope;
Fig. 2 is a configuration diagram showing an example of a sample-moving stage used in the conventional scanning electron microscope;
Fig. 3 is an external view taken along line A-A in Fig. 2 ;
Fig. 4 is an external view taken along line B-B in Fig. 2 ;
Fig. 5 is a configuration diagram showing a sample-moving stage used in an embodiment of the invention and in a first example related to the present invention;
Fig. 6 is an external view taken along line C-C in Fig. 5 ;
Fig. 7 is a diagram that shows connection of stepping motor power supplies in Fig. 5 ;
Fig. 8 is a diagram showing a heater of an x-motor section of a sample stage used in a second example related to the invention of the present invention;
Fig. 9 is a diagram showing a heater of a y-motor section of the sample stage used in the second example related to the invention of the present invention; and

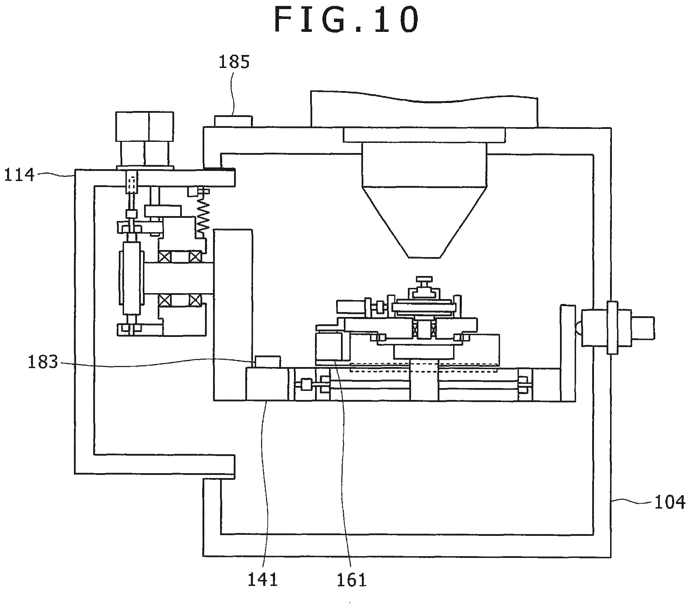

Fig. 10 is a configuration diagram showing a temperature gauge used in a third example related to the invention of the present invention.

**Modes for Carrying Out the Invention**

**(First Example)**

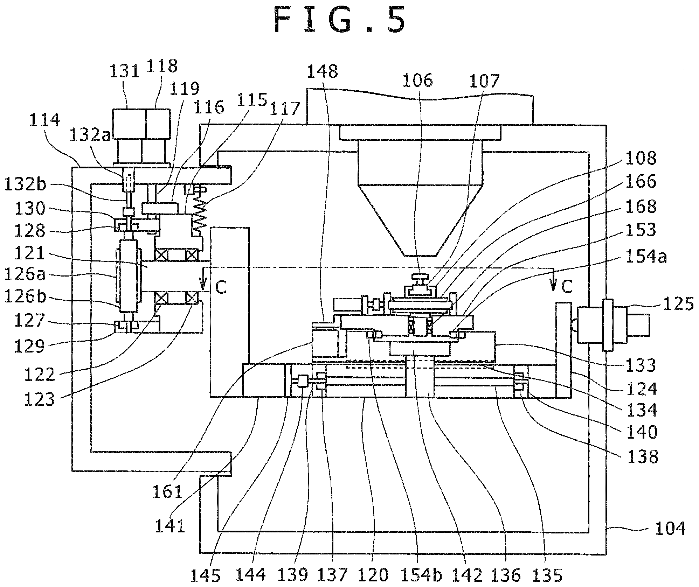

The present invention is described below in accordance with illustrated embodiment and examples related to the invention. One Embodiment of and example related to the present invention are shown in Figs. 5 to 7 .

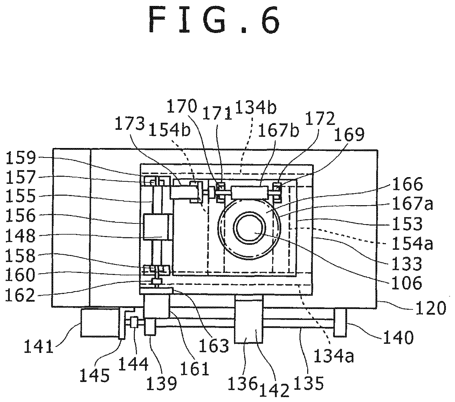

Fig. 6 shows an external view taken along line C-C in Fig. 5 . A stage casing 114 is connected to a sample chamber 104, and a z-table system and a tilting table driving system, both mounted in the stage casing 114, are basically the same as in prior art. A z-table 115 is coupled to the stage casing 114 via a cross roller bearing (not shown). The z-table 115 is pulled upward by a spring 117 and then driven by a z-stepping motor 118 to move a z-moving shaft 119 vertically and thus to be guided along the cross roller bearing and move in a z-direction. As a result, the z-table 115 moves a sample 106 in the z-direction. The z-moving shaft 119 is male-threaded, and the male-threaded section of the z-moving shaft 119 and a female-threaded section 116 of the z-table 115 work together to move the z-table 115 vertically.

A tilting shaft 121 is mounted at one end of a tilting table 120, and the tilting shaft 121 is pivotally coupled to the z-table 115 via roller bearings 122 and 123. A locking plate 124 is mounted at the other end of the tilting table 120 and pushed by a stage-locking mechanism 125 mounted in the sample chamber 104. A worm wheel 126a is fitted at an end of the tilting shaft 121, and a worm gear 126b formed to be combined with the worm wheel 126a is supported by ball bearings 127 and 128 and connected to the z-table 115 at bearing housings 129 and 130. The worm wheel 126a and a T-stepping motor 131 that rotates the worm gear 126b are coupled to each other by spline shafts 132a and 132b so as to be able to follow a movement of the z-table 115 in the z-direction. Rotation of the T-stepping motor 131 rotates the tilting shaft 121, thus tilts the sample 106, and retains the sample 106 at a fixed tilt angle.

An x-table 133 that moves the sample 106 in an x-direction is mounted on the tilting table 120 via a cross roller guide 134. The x-table 133 is driven by a feed action of an x-ball screw 135 and an x-ball screw nut 136. The x-ball screw nut 136 is fixed to the x-table 133 via an x-connector 142. The x-ball screw 135 is supported at both ends thereof by ball bearings 137 and 138, and is connected to the tilting table 120 at bearing housings 139 and 140. The x-ball screw 135 is connected to an x-stepping motor 141 via an x-coupling 144, the x-stepping motor 141 is supported by an x-bracket 145, and the x-bracket 145 is fixed to the tilting table 120. The x-table 133 drives the x-stepping motor 141 to rotate the x-ball screw 135 and feed the x-ball screw nut 136. This feed action moves the x-table 133 in the x-direction, hence moving the sample 106 in the x-direction.

A y-table 153 is mounted on the x-table 133 via cross roller guides 154a and 154b. The y-table 153 is driven by a feed action of a y-ball screw 155 and a y-ball screw nut 156. The y-ball screw nut 156 is fixed to the y-table 153 via a y-connector 148. The y-ball screw 155 is supported at both ends thereof by ball bearings 157 and 158, and is connected to the x-table 133 at bearing housings 159 and 160. The y-ball screw 155 is also connected to a y-stepping motor 161 via a y-coupling 162, the y-stepping motor 161 is supported by a y-bracket 163, and the y-bracket 163 is fixed to the x-table 133. The y-table 153 drives the y-stepping motor 161 to rotate the y-ball screw 155 and feed the y-ball screw nut 156. This feed action moves the y-table 153 in a y-direction, hence moving the sample 106 in the y-direction.

A rotation table 166 has a worm wheel 167a and is pivotally coupled to the y-table 153 by a ball bearing 168. A worm gear 167b is supported at both ends thereof by ball bearings 169 and 170, and is connected to the y-table 153 at bearing housings 171 and 172. The worm gear 167b is rotated by a DC motor 173. Rotation of the DC motor 173 turns the worm gear 167b and the worm wheel 167a, thus rotating the rotation table 166 and hence the sample 106.

The sample 106 is mounted in bonded form on a sample holder 107, and the sample holder 107 is inserted in and fixed to a holder stage 108 mounted on the rotation table 166.

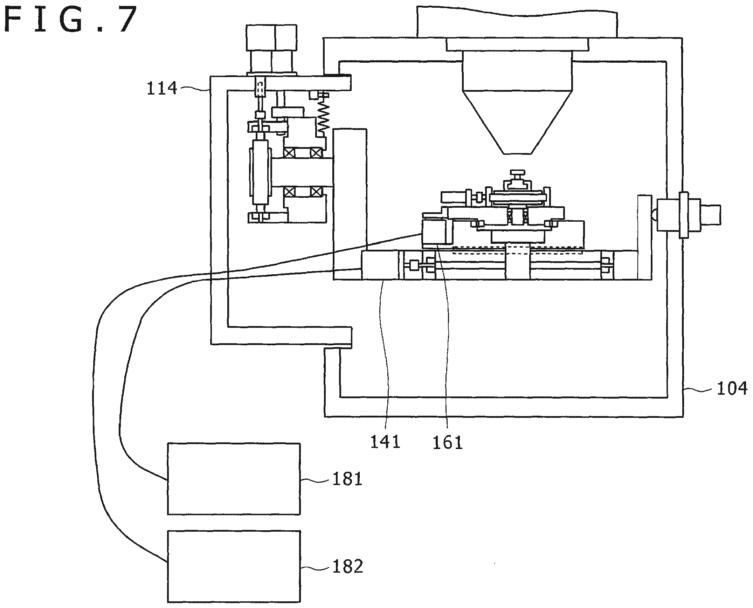

As shown in Fig. 7 , the x-stepping motor 141 is connected to an x-stepping motor power supply 181 placed in the atmosphere, via a current lead-in terminal (not shown) that is provided in/on the stage casing 114, and the y-stepping motor 161 is likewise connected to a y-stepping motor power supply 182. Supply currents from the power supplies to the stepping motors during the movement of the sample and a stop of the sample movement are controlled to be of the same level or so that a maximum difference in level between the supply currents is 20%. This control for minimal changes in the levels of the sample-moving and sample-stopping currents lessens any changes in temperatures of the motors, thereby minimizing any changes in a temperature of the sample stage due to heat from the motors, and reducing sample drift.

In experiments of the present inventors, an object to be observed is moved from a location to nearly a screen center of the scanning electron microscope, for drift measurement. From this position, the object is further moved through 40 mm in directions of both x- and y-axes, and after this movement, the object is immediately moved through 40 mm in an opposite direction to return to its immediately previous position. After this movement, drifts of the object are measured.

Sample drift was measured under two different states. In one of the two states, the supply current levels during the sample-moving operation and sample-stopping operation of the stepping motors were set to differ by 50%, and in the other state, the supply current levels were set to be the same. Through comparison of measurement results, the present inventors confirmed that setting the same supply current level in accordance with the present embodiment reduces the drift to 2/5 of its initial value.

**(Embodiment of the Invention)**

In a sample stage substantially of the same configuration as that of the first example related to the invention, since the y-table 153 is mounted above the x-table 133, even if the y-stepping motor 161 has a small torque compared with that of the x-stepping motor 141, the y-table 153 can be moved with the same response characteristics. For this reason, the level of the supply current from the y-stepping motor power supply 182 to the y-stepping motor 161 can be reduced below the level of the current supplied from the x-stepping motor power supply 181.

The experiments of the present inventors indicate that even if the supply current level of the y-stepping motor power supply 182 is set to be either the same as, or reduced to 2/3 of, that of the x-stepping motor power supply 181, the sample properly moves without a problem. However, the supply current settings of the x- and y-stepping motor power supplies may both be changed according to torque, and the above range is not limited if the supply current levels of the two power supplies are set to differ.

In the present embodiment, after the sample stage has been moved in substantially the same form as in the first example related to the invention, the sample drift is measured under the settings that the supply current level of the y-stepping motor power supply is 2/3 of that of the x-stepping motor power supply and that the slight-sample-moving and sample-stopping current levels are the same. As a result, it was confirmed that the sample drift is reduced to 1/3 of that caused by a temperature change under the conditions that the power supply settings are the same and the sample-moving and sample-stopping current levels are different.

**(Second Example Related to the Invention)**

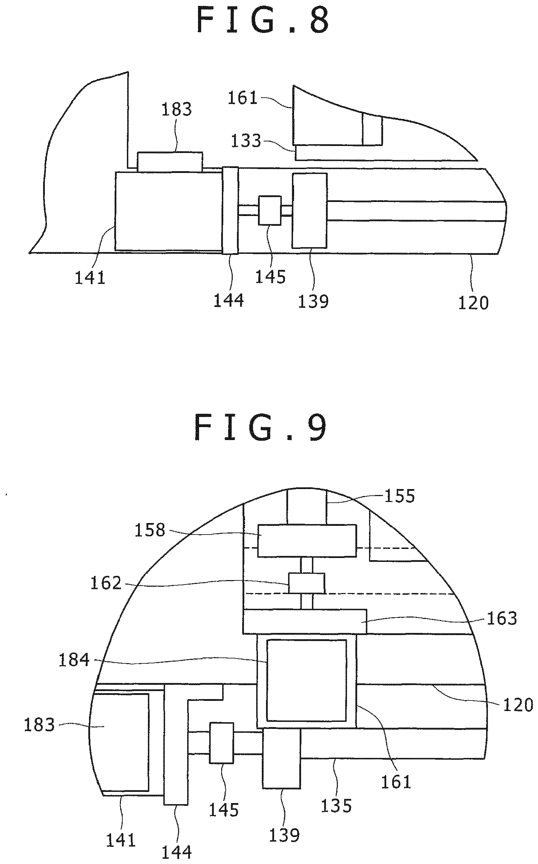

Although substantially the same in configuration as in the first example related to the invention, a sample stage including an x-heater 183 disposed on the x-stepping motor 141, as shown in Fig. 8 , and a y-heater 184 disposed on the y-stepping motor 161, as shown in Fig. 9 , was used in a second example related to the invention.

In the present example related to the invention, the supply current levels of the stepping motor power supplies 181 and 182 during a stop of sample movement were set to be 50% of those obtainable during slight movement of the sample, and heaters with an output of 5 W were used as the heaters 183 and 184 in order to accommodate temperature changes by accommodating changes in the amounts of heat generated by the stepping motors 141 and 161 during the sample-moving and sample-stopping operation. The difference between the sample-moving and sample-stopping supply current levels, and the amounts of heat generated by the heaters may be adjusted according to temperature change, and if the heaters are provided, capabilities of the heaters are not limited.

In experiments of the present inventors, heating by the heaters was started immediately after the sample-moving operation was stopped for observation. Through the experiments, it was confirmed that sample drift is reduced to 2/5 with the use of the present example related to the invention.

**(Third Example Related to the Invention)**

Although substantially the same in configuration as in the second example related to the invention, a sample stage with a 20-W heater as the heater 183, and not including the heater 184, was used, and the sample chamber includes a temperature gauge 185 for detecting a change in a temperature in a third example related to the invention. While the temperature gauge 185 used a chromel-alumel thermocouple in the present example related to the invention, the temperature gauge does not have its material and type limited, only if it has a function that detects temperature. In addition, while the heater 183 was provided as a heater on the x-stepping motor, the heater does not have its location limited to the motor section and may be mounted on the x-table 133, the y-table 153, the tilting table 120, the z-table 115, or some other appropriate section of the sample stage; a mounting site of the heater on the sample stage, provided with the temperature detection function, is not specified.

Through experimentation, the present inventors confirmed that temperature drift can be reduced by setting the heater so that output P of the heater in response to a change in temperature T of the temperature gauge 185 varies in accordance with the following relational expression:

$$P = 0.02 \times (T - 50)^2$$

The relational expression of output P and temperature T, however, depends upon the mounting position and capability of the heater. Use of this expression, therefore, is not specified and it suffices if the sample stage is constructed to reduce the sample drift according to the particular change in temperature.

Through experimentation, the present inventors confirmed that the sample drift due to a change in the internal temperature of the sample chamber is reduced to 1/5 in comparison with that occurring when the present example related to the invention is not used.

## Description of Reference Numbers

[0038]

| 1 | Electron gun |
|---|---|
| 3 | Objective lens |
| 4 | Sample chamber |
| 5 | Sample-moving stage |
| 6 | Sample |
| 14 | Stage casing |
| 15 | z-table |
| 16a, 16b | Cross roller guides |
| 18 | z-stepping motor |
| 19 | z-moving shaft |
| 20, 120 | Tilting tables |
| 21 | Tilting shaft |
| 22, 23 | Roller bearings |
| 26a | Worm wheel |
| 26b | Worm gear |
| 31 | T-stepping motor |
| 32a, 32b | Spline shafts |
| 33, 133 | x-tables |
| 41, 141 | x-stepping motor |
| 42 | x-stage joint |
| 43, 153 | y-tables |
| 54, 161 | y-stepping motors |
| 55 | y-stage joint |
| 56, 166 | Rotation tables |
| 63, 173 | DC motors |
| 106 | Sample |
| 114 | Stage casing |
| 135 | x-ball screw |
| 155 | y-ball screw |
| 181 | x-stepping motor power supply |
| 182 | y-stepping motor power supply |
| 183 | x-heater |
| 184 | y-heater |
| 185 | Temperature gauge |

## Claims

1. A method for operating a scanning electron microscope including
a sample-moving stage for moving a sample, wherein the sample-moving stage includes:

an x-table (133) for moving the sample in an x-direction right-angled to an electron beam,
a y-table (153) for moving the sample in a y-direction right-angled to the x-direction as well as to the electron beam, the y-table being mounted above the x-table,
a z-table (115) configured to move in a same z-direction as the direction in which the electron beam travels,

a rotation table (166) for rotating the sample in a plane parallel to an x-y plane, and
a tilting table (120) for imparting a tilting action to the sample,
the x-table (133) being mounted on the tilting base,
the x-table (133) and the y-table (153) each being configured for being moved by a motor (141, 161) disposed in a sample chamber (104), each of the motors (141, 161) being connected to a ball screw (135, 155) via a coupling (142, 162), the electron beam being scanned on the sample surface, thereby allowing a detector to detect a signal originating from the sample, and
the signal detected by the detector being used to display an image of the sample,

**characterized in that** the method includes lessening changes in the amounts of heat generated by the motors (141, 161) by controlling supply currents to the motors (141, 161) so that the supply currents have, during the movement of the sample and a stop of the sample movement, the same level or a maximum difference in level of 20% with respect to the supply current during a movement of the sample, for controlling the temperature of the sample stage to reduce sample drift during observation,
wherein the controlling of the temperature further comprises an operation for the motor (161) for the y-table (153), with a supply current that is lower than the supply current for the motor (141) of the x-table (133).

## Patentansprüche

1. Verfahren zum Betreiben eines Rasterelektronenmikroskops, welches einen Probenverschiebetisch zum Bewegen einer Probe umfasst, wobei der Probenverschiebetisch umfasst:

einen x-Tisch (133) zum Bewegen der Probe in einer x-Richtung in einem rechten Winkel zu einem Elektronenstrahl,
einen y-Tisch (153) zum Bewegen der Probe in einer y-Richtung in einem rechten Winkel zu der x-Richtung sowie zu dem Elektronenstrahl, wobei der y-Tisch über dem x-Tisch angebracht ist,
einen z-Tisch (115), der so konfiguriert ist, dass er sich in der selben z-Richtung bewegt wie die Richtung, in welcher der Elektronenstrahl gestrahlt wird,
einen Drehtisch (166) zum Drehen der Probe in einer Ebene parallel zu einer x-y-Ebene, und
einen Kipptisch (120), um eine Kippbewegung der Probe zu erzeugen,
wobei der X-Tisch (133) auf der Kippbasis montiert ist,

der x-Tisch (133) und der y-Tisch (153) jeweils so konfiguriert sind, dass sie durch einen in einer Probenkammer (104) angeordneten Motor (141, 161) bewegt werden, wobei jeder der Motoren (141, 161) über eine Kupplung (142, 162) mit einer Kugelumlaufspindel (135, 155) verbunden ist,

der Elektronenstrahl über die Probenoberfläche gescannt wird, wodurch ein Detektor ein von der Probe stammendes Signal erfassen kann, und wobei das von dem Detektor erfasste Signal zur Darstellung eines Bildes der Probe verwendet wird,

**dadurch gekennzeichnet, dass** das Verfahren das Verringern von Änderungen in den von den Motoren (141, 161) erzeugten Wärmemengen durch Steuern von Versorgungsströmen zu den Motoren (141, 161) umfasst, so dass die Versorgungsströme während der Bewegung der Probe und eines Stopps der Bewegung der Probe den gleichen Pegel oder einen maximalen Pegelunterschied von 20 % in Bezug auf den Versorgungsstrom während einer Bewegung der Probe haben, um die Temperatur des Probentisches zu steuern, um eine Probendrift während der Erfassung zu verringern,

wobei die Steuerung der Temperatur ferner einen Betrieb für den Motor (161) für den y-Tisch (153) mit einem Versorgungsstrom umfasst, der niedriger ist als der Versorgungsstrom für den Motor (141) des x-Tisches (133).

**Revendications**

1. Procédé de fonctionnement d'un microscope électronique à balayage incluant une platine de déplacement d'échantillon pour déplacer un échantillon, dans lequel la platine de déplacement d'échantillon inclut :

une table des x (133) pour déplacer l'échantillon dans un sens des x à angle droit par rapport à un faisceau d'électrons,
une table des y (153) pour déplacer l'échantillon dans un sens des y à angle droit par rapport au sens des x ainsi qu'au faisceau d'électrons, la table des y étant montée au-dessus de la table des x,
une table des z (115) configurée pour se déplacer dans un même sens des z que le sens dans lequel le faisceau d'électrons progresse,
une table de rotation (166) pour faire tourner l'échantillon dans un plan parallèle à un plan x-y, et
une table de basculement (120) pour impartir une action de basculement à l'échantillon,
la table des x (133) étant montée sur la base de basculement,
la table des x (133) et la table des y (153) étant chacune configurée pour être déplacée par un moteur (141, 161) disposé dans une chambre (104) d'échantillon, chacun des moteurs (141, 161) étant connecté à une vis sphérique (135, 155) par l'intermédiaire d'un accouplement (142, 162),

le faisceau d'électrons étant balayé sur la surface d'échantillon, permettant ainsi à un détecteur de détecter un signal provenant de l'échantillon, et

le signal détecté par le détecteur étant utilisé pour afficher une image de l'échantillon,

**caractérisé en ce que** le procédé inclut la diminution de changements des quantités de chaleur générées par les moteurs (141, 161) en commandant des courants d'alimentation des moteurs (141, 161) de telle manière que les courants d'alimentation ont, lors du mouvement de l'échantillon et d'un arrêt du mouvement d'échantillon, le même niveau ou une différence maximum de niveau de 20% par rapport au courant d'alimentation lors d'un mouvement de l'échantillon, pour commander la température de la platine d'échantillon afin de réduire une dérive d'échantillon pendant l'observation,

dans lequel la commande de la température comprend en outre une opération pour le moteur (161) pour la table des y (153), avec un courant d'alimentation qui est plus faible que le courant d'alimentation pour le moteur (141) pour la table des x (133).

# FIG.1

FIG.2

EP 2 573 794 B1

9

# F I G . 3

# F I G . 4

# FIG.5

EP 2 573 794 B1

# FIG.6

# FIG.7

114

104

141    161

181

182

EP 2 573 794 B1

# FIG.8

# FIG.9

# FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9223477 B
- JP H11235082 A

- JP 10129985 A